# EUROPÄISCHE PATENTANMELDUNG

(11) **EP 1 347 577 A2**
(43) Veröffentlichungstag der Anmeldung: **24.09.2003**
(21) Anmeldenummer: 03005267.4
(22) Anmeldetag: 10.03.2003
(51) Int. Cl.: H03K 17/0812

(54) **Ansteuerschaltung für einen Sperrschicht-Feldeffekttransistor**

(30) Priorität: 22.03.2002 DE 10212869
(71) Anmelder: SIEMENS AKTIENGESELLSCHAFT, 80333 München (DE)
(72) Erfinder: Braun, Matthias, 63639 Flörsbachtal (DE); Weis, Benno, 91334 Hemhofen (DE)

(57) **Zusammenfassung**

Ansteuerschaltung für einen Anschlüsse für Gate (G), Drain (D) und Source (S) aufweisenden Sperrschicht-Feldeffekttransistor (T1, T2, T4, T7, JFET) mit einer steuerbaren Strom- oder Spannungsquelle zur Erzeugung eines Sperrsteuerstromes bzw. einer Sperrsteuerspannung für das Gate (G), wobei die Strom- bzw. Spannungsquelle derart gesteuert wird, dass beim Ausschalten des Sperrschicht-Feldeffekttransistors der Sperrsteuerstrom bzw. die Sperrsteuerspannung zunächst einen betragsmäßig höheren Wert und dann einen betragsmäßig niedrigeren Wert annimmt und bereits der niedrigere Wert zum Sperren des Sperrschicht-Feldeffekttransistors ausreichend ist.

## Beschreibung

Die Erfindung betrifft eine Ansteuerschaltung für einen Sperrschicht-Feldeffekttransistor.

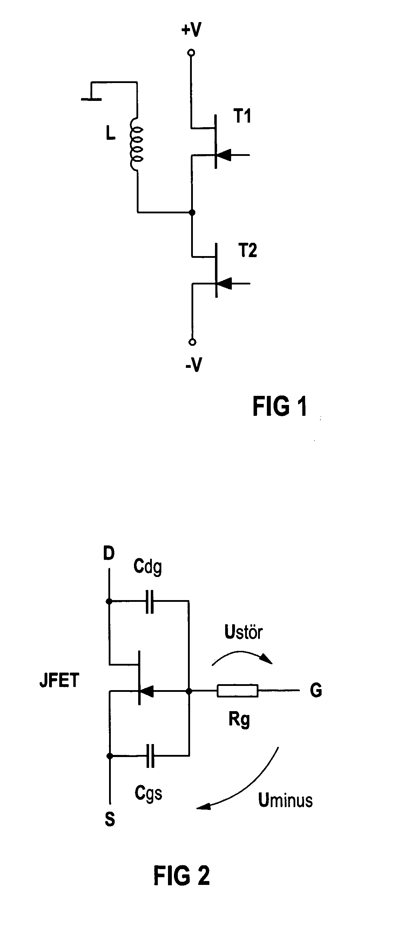

In FIG 1 ist eine Wechselrichteranordnung mit Sperrschicht-Feldeffekttransistoren (JFETs) dargestellt. Die hier eingesetzten Sperrschicht-Feldeffekttransistoren sind selbst leitende Bauelemente, die beispielsweise aus U. Tietze, Ch. Schenk, Halbleiter-Schaltungstechnik, 9. Auflage 1990, Seiten 83 bis 101 bekannt sind. Bei einer Spannung am Gate von 0 V sind derartige Sperrschicht-Feldeffekttransistoren leitend und bei negativen Gate-Spannungen sperrend. Darüber hinaus kann der Sperrschicht-Feldeffekttransistor (im eingeschalteten Zustand) den Strom in beide Richtungen leiten. Er stellt somit ein symmetrisches Bauelement dar. Weiterhin besitzt der Sperrschicht-Feldeffekttransistor in Rückwärtsrichtung (Source-Drain-Richtung) eine strukturbedingte pin-Diode, die ebenfalls einen Strom in Rückwärtsrichtung unabhängig von der Gate-Spannung zulässt. Mit einem derartigen Sperrschicht-Feldeffekttransistor kann ohne weiteres ein diodenfreier Wechselrichter realisiert werden.

Schematisch dargestellt weist eine Wechselrichteranordnung gemäß FIG 1 beispielsweise zwei Sperrschicht-Feldeffekttransistoren T1 und T2 auf, deren Drain-Source-Strecken in Reihe zueinander zwischen ein positives Versorgungspotential +V und ein negatives Versorgungspotential -V geschaltet sind. Im einzelnen ist der Drain-Anschluss des Sperrschicht-Feldeffekttransistors T1 mit dem positiven Versorgungspotential +V und der Source-Anschluss des Sperrschicht-Feldeffekttransistors T2 mit dem negativen Versorgungspotential -V verbunden. Der Source-Anschluss des Sperrschicht-Feldeffekttransistors T1 und der Drain-Anschluss des Sperrschicht-Feldeffekttransistors T2 sind miteinander sowie mit einem Anschluss einer Last L verbunden, deren anderer Anschluss an ein Massepotential, das zwischen den Versorgungspotentialen +V, -V liegt oder gleich einem dieser Versorgungspotentiale +V, -V ist, angeschlossen ist.

Es sei angenommen, dass ein Strom in dem Zweig bestehend aus der Last L und der Drain-Source-Strecke des Sperrschicht-Feldeffekttransistors T1 frei läuft. Die Gate-Source-Spannung des Sperrschicht-Feldeffekttransistors T1 ist hierbei negativ, wobei von einem ausgeschalteten Sperrschicht-Feldeffekttransistor vom n-Leitungstyp ausgegangen wird. Der Freilaufstrom fließt dann über die interne Freilaufdiode des Sperrschicht-Feldeffekttransistors T1. Wird nun der Sperrschicht-Feldeffekttransistor T2 eingeschaltet, kommutiert der Strom vom Sperrschicht-Feldeffekttransistor T1 auf den Sperschicht-Feldeffekttransistor T2 über. Somit baut der Sperrschicht-Feldeffekttransistor T2 seine Sperrspannung ab und der Sperrschicht-Feldeffekttransistor T1 baut Sperrspannung auf. Um hierbei möglichst verlustarm zu schalten, werden hohe Schaltgeschwindigkeiten angestrebt.

In FIG 2 sind die parasitären dynamischen Ersatzelemente eines Sperrschicht-Feldeffekttransistors JFET dargestellt. Im einzelnen sind dies eine parasitäre Kapazität zwischen Drain D und Gate G (Kapazität Cdg), eine parasitäre Kapazität zwischen Gate G und Source S (Kapazität Cgs) sowie ein dem Gate vorgeschalteter Gatewiderstand Rg, über dem eine Störspannung Ustör abfällt, wenn eine Spannung Uminus zwischen Gate G und Source S angelegt wird. Da das Gate G des Sperrschicht-Feldeffekttransistors JFET immer ein Potential nahe dem Source-Potential annimmt, sind die Drain-Source-Spannung und die Drain-Gate-Spannung des Sperrschicht-Feldeffekttransistors JFET in erster Näherung identisch. Nimmt nun bei dem in FIG 1 gezeigten Beispiel der Sperrschicht-Feldeffekttransistor T1 schnell Spannung auf, d.h. die Drain-Source-Spannung steigt sehr schnell auf hohe Werte an, so steigt die Drain-Gate-Spannung in gleichem Maße auf hohe Werte. Durch die unvermeidbare Drain-Gate-Kapazität Cdg (Miller-Kapazität) erzwingt dieser Spannungsanstieg einen Stromfluss aus dem Gate G des Sperrschicht-Feldeffekttransistors JFET heraus. Dieser Strom muss über den Gate-Widerstand Rg fließen und verursacht dort den Spannungsabfall Ustör, der das Gate-Potential gegenüber der äußeren Steuerspannung Uminus anhebt. Der Spannungsabfall Ustör ist dabei proportional zum Gate-Widerstand Rg und zur Schaltsteilheit dUdg/dt. Wird dieser Spannungsabfall so groß, dass das Gate-Potential in die Nähe des Source-Potentials angehoben wird, so schaltet der Sperrschicht-Feldeffekttransistor JFET (in FIG 1 der Sperrschicht-Feldeffekttransistor T1) ein und es entsteht ein Brückenkurzschluss, da der Sperrschicht-Feldeffekttransistor T2 in FIG 1 definitionsgemäß ebenfalls eingeschaltet ist.

Üblicherweise wird das Potential Uminus so gewählt, dass der Spannungsabfall Ustör nicht ausreicht, um das Gate-Potential so weit anzuheben, dass der Sperrschicht-Feldeffekttransistor JFET einschaltet. Hierzu wird auch der Widerstand Rg möglichst klein gewählt.

Bei Ausführungsformen von Silizium-Carbid-Sperrschicht-Feldeffekttransistoren sind jedoch Mindestwerte für den Gate-Widerstand Rg und die Drain-Gate-Kapazität Cdg technologisch vorgegeben. Dabei sind beide und insbesondere der Gate-Widerstand Rg so groß, dass bei einer akzeptablen Schaltgeschwindigkeit (beispielsweise 1000 V/µs) der Spannungsabfall Ustör größer als die maximale Sperrfähigkeit der Gate-Source-Strecke wird. Würde das Ansteuerpotential Uminus soweit abgesenkt, dass der Spannungsabfall Ustör nicht zu einem fehlerhaften Einschalten führt, dann würde in der Regel die Gate-Source-Strecke des Sperrschicht-Feldeffekttransistors thermisch zerstört, da der Spannungsabfall Ustör nur sehr kurzfristig auftritt und während der restlichen Zeit eine sehr hohe negative Gate-Spannung am Sperrschicht-Feldeffekttransistor anliegt. Diese würde zu einem unzulässig hohen Gate-Strom führen. Somit sind die bekannten Maßnahmen bei Silizium-Carbid-Feldeffekttransistoren nicht einsetzbar.

Demnach besteht nur noch die Möglichkeit, die Schaltgeschwindigkeit des Sperrschicht-Feldeffekttransistors zu reduzieren, um den Spannungsabfall Ustör zu verringern. Dies hat aber einen starken, nicht akzeptablen Anstieg der Schaltverluste zur Folge.

Es ist folglich Aufgabe der Erfindung, eine Ansteuerschaltung für einen Sperrschicht-Feldeffekttransistor anzugeben, die diese Nachteile nicht aufweisen.

Die Aufgabe wird gelöst durch eine Ansteuerschaltung gemäß Patentanspruch 1. Ausgestaltungen und Weiterbildungen des Erfindungsgedankens sind Gegenstand von Unteransprüchen.

Im einzelnen umfasst eine erfindungsgemäße Ansteuerschaltung für einen Anschlüsse für Gate, Drain und Source aufweisenden Sperrschicht-Feldeffekttransistor eine steuerbare Strom- oder Spannungsquelle zur Erzeugung eines Sperrstromes bzw. einer Sperrspannung für das Gate, wobei die Strom- bzw. Spannungsquelle derart gesteuert wird, dass beim Ausschalten des Sperrschicht-Feldeffekttransistors der Sperrsteuerstrom bzw. die Sperrsteuerspannung zunächst einen betragsmäßig höheren Wert und dann einen betragsmäßig niedrigeren Wert annimmt und bereits der niedrigere Wert zum Sperren des Sperrschicht-Feldeffekttransistors ausreichend ist. Erfindungsgemäß wird die Gate-Source-Spannung des Sperrschicht-Feldeffekttransistors in einem Bereich gehalten, der ein sicheres Ausschalten gewährleistet, ohne die Gate-Source-Strecke spannungsmäßig zu überlasten. Es wird also das Steuerpotential Uminus während des Schaltvorgangs dynamisch abgesenkt. Ist die statische Gate-Spannung beispielsweise auf -17V eingestellt, könnte diese für den Abkommutierungsvorgang beispielsweise auf -27 V eingestellt werden. Somit kann durch den Spannungsabfall Ustör ein Einschalten des Sperrschicht-Feldeffekttransistors T1 aus FIG 1 unterbunden werden. Da die Absenkung der Gate-Spannung nur für den Abkommutierungsvorgang durchgeführt wird, ist die zusätzliche Erwärmung durch den erhöhten Gate-Strom vernachlässigbar. Jedoch können das Aufsteuern und somit ein Querstrom vermieden werden.

Alternativ kann zur Ansteuerspannung Uminus auch der Gate-Strom insbesondere der Gate-Leckstrom betragsmäßig angehoben werden. Dazu wird im Normalbetrieb ein gewisser Soll-Leckstrom eingestellt. Beim Abkommutieren wird ein erhöhter Leckstrom bereitgestellt, der den Störstrom durch die Miller-Kapazität berücksichtigt. Somit kann der gesamte Strom aus der Miller-Kapazität "abgesaugt" und ein Anstieg der Gate-Spannung verhindert werden.

Vorzugsweise wird für die Stromquelle bzw. Spannungsquelle eine Zeitsteuerung vorgesehen, die bei Auftreten einer das Ausschalten des Sperrschicht-Feldeffekttransistors einleitenden Flanke eines Schaltsignals den Sperrsteuerstrom bzw. die Sperrsteuerspannung von dem niedrigeren Wert für eine Überhöhungs-Zeitdauer auf den höheren Wert erhöht.

Vorzugsweise wird der höhere Wert des Sperrsteuerstroms bzw. der Sperrsteuerspannung ungefähr gleich dem maximal zulässigen Wert für den Gate-Strom bzw. die Gate-Spannung gesetzt.

Vorzugsweise wird als Sperrschicht-Feldeffekttransistor ein Silizium-Carbid-Feldeffekttransistor vorgesehen.

Bei der erfindungsgemäßen Ansteuerschaltung ist folglich eine Umschaltung zwischen zwei unterschiedlichen Werten des Sperrsteuerstroms bzw. der Sperrsteuerspannung vorgesehen. Die Überhöhung der Ansteuerung wird vorzugsweise immer dann eingesetzt, wenn eine interne Freilaufdiode (parasitäre Diode eines Sperrschicht-Feldeffekttransistors) leitend war und der jeweils andere Sperrschicht-Feldeffekttransistor des gleichen Brückenzweigs einschaltet.

Da es schwierig ist, den Einschaltzeitpunkt über eine gegebenenfalls vorhandene Potentialtrennung zu übertragen, wird der Befehl zur Sollwertumschaltung zweckmäßigerweise mit dem Ausschaltbefehl für den Sperrschicht-Feldeffekttransistor selbst verknüpft. Die Anhebung muss dann mindestens so lange wie die Wechselsperrzeit dauern, da während dieser das oben beschriebene unerwünschte Verhalten auftritt. Nach einer gegebenenfalls weiteren Sicherheits-Zeitspanne kann wieder auf den stationären, d.h. den kleineren Sollwert umgeschaltet werden.

Die Erfindung wird nachfolgend anhand der in den Figuren der Zeichnung dargestellten Ausführungsbeispiele näher erläutert. Es zeigt:
- FIG 1: die schematische Darstellung einer Wechselrichteranordnung,
- FIG 2: das Ersatzschaltbild eines Sperrschicht-Feldeffekttransistors,
- FIG 3: ein Ausführungsbeispiel einer erfindungsgemäßen Ansteuerschaltung,
- FIG 4: ein zweites Ausführungsbeispiel einer erfindungsgemäßen Ansteuerschaltung und
- FIG 5: ein drittes Ausführungsbeispiel einer erfindungsgemäßen Ansteuerschaltung.

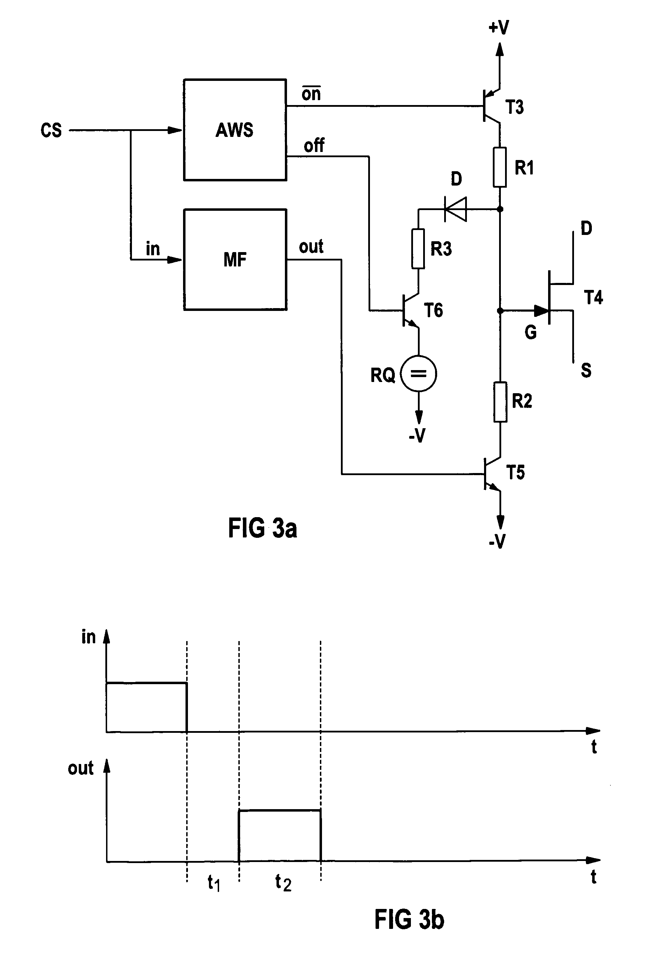

Bei dem in FIG 3a gezeigten Ausführungsbeispiel wird ein Schaltsignal CS einer Auswerteschaltung AWS zugeführt, die daraus zwei komplementäre Steuersignale on und off mit unterschiedlichen Pegellagen erzeugt. Des weiteren wird das Schaltsignal CS einem monostabilen Multivibrator MF zugeführt, der auf einen eingehenden Impuls zeitverzögert einen ausgehenden Impuls erzeugt. An ein positives Versorgungspotential +V ist dabei der Emitter eines Bipolartransistors T3 vom pnp-Typ angeschlossen, dessen Basis durch das Signal on der Auswerteschaltung AWS gesteuert wird. Der Kollektor des Bipolartransistors T3 ist über einen Widerstand R1 auf einen Knotenpunkt geführt, an dem auch die Anode einer Diode D2, ein Anschluss eines Widerstands R2 sowie das Gate eines zu schaltenden Silizium-Carbid-Transistors, nämlich des Sperrschicht-Feldeffekttransistors T4, angeschlossen sind. Der andere Anschluss des Widerstandes R2 ist auf den Kollektor eines Bipolartransistors T5 vom npn-Typ geführt, dessen Emitter an einem negativen Versorgungspotential -V und dessen Basis an den Ausgang des monostabilen Multivibrators MF angeschlossen ist.

Die Katode der Diode D2 ist schließlich unter Zwischenschaltung eines Widerstandes R3 auf den Kollektor eines Bipolartransistors T6 vom npn-Typ geführt, dessen Basis mit dem Signal off der Auswerteschaltung AWS gesteuert wird und dessen Emitter über eine Referenzspannungsquelle RQ an dem negativen Versorgungspotential -V angeschlossen ist.

Der "normale" Sollwert wird dabei mittels der Referenzspannungsquelle RQ in Verbindung mit dem Bipolartransistor T6, dem Widerstand R3 und der Diode D2 beim Abschalten an das Gate des Sperrschicht-Feldeffekttransistors T4 gelegt. Jedoch wird zudem die Spannung für eine durch den monostabilen Multivibrator MF vorgegebene Zeitdauer mittels des Bipolartransistors T5 auf das negative Versorgungspotential -V aufgeschaltet.

Der Verlauf der Eingangssignale in und der Ausgangssignale out des monostabilen Multivibrators MF ist in FIG 3b dargestellt. Auf die negative Flanke eines Eingangsimpulses wird nach einer Totzeit t₁ ein (damit verzögerter) Impuls mit der Dauer t₂ erzeugt.

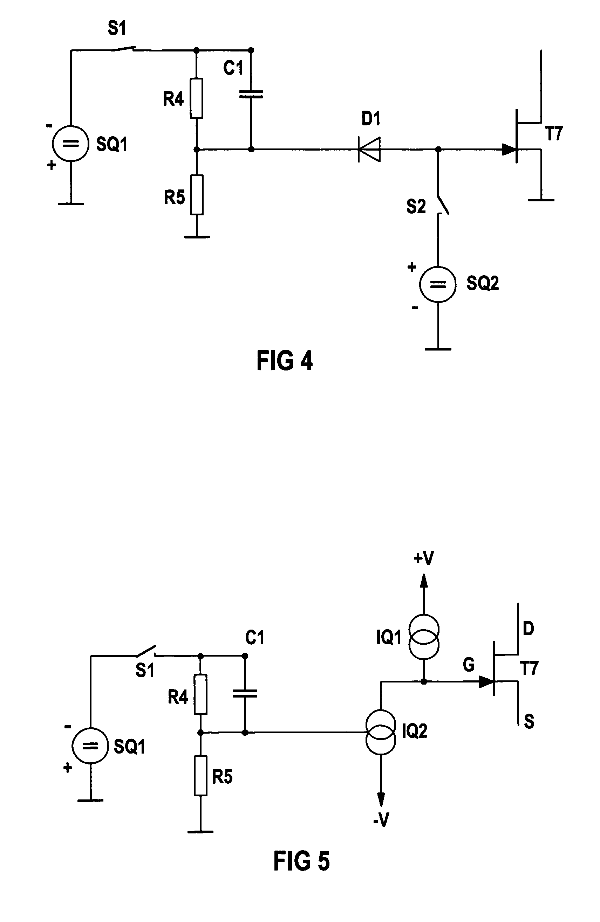

In FIG 4 ist das Schaltbild einer anderen Ausgestaltung einer erfindungsgemäßen Aussteuerschaltung für einen Silizium-Carbid-Sperrschicht-Feldeffekttransistor T7 dargestellt. Der Sperrschicht-Feldeffekttransistors T7 ist beim vorliegenden Ausführungsbeispiel vom n-Kanal-Typ, so dass er durch eine negative Spannung abgeschnürt wird und im Normalfall leitend ist. Beim Ausführungsbeispiel wird im leitenden Zustand jedoch eine leicht positive Spannung angelegt, um ein sicheres Leiten zu gewährleisten. Dazu ist das Gate mit einem Anschluss eines Schalters S2 verbunden, dessen anderer Anschluss an dem positiven Pol einer Spannungsquelle SQ2 angeschlossen ist. An das Gate ist zudem die Anode einer Diode D1 angeschlossen, deren Katode auf den Abgriff eines Spannungsteilers geführt ist, welcher aus zwei Widerständen R4 und R5 besteht. Der Widerstand R5 führt dabei gegen Masse, während über den Widerstand R4 sowie einen zum Schalter S2 invers betriebenen Schalter S1 eine durch eine Spannungsquelle SQ1 erzeugte negative Spannung auf den Abgriff aufschaltbar ist. Parallel zum Widerstand R4 ist ein Kondensator C1 geschaltet. Obwohl hier mechanischer Schalte S1 und S2 gezeigt sind, handelt es sich um gesteuerte Schalter wie beispielsweise Transistoren.

Bei geöffnetem Schalter S1 wird durch die Spannungsquelle SQ2 eine positive Spannung an das Gate des Transistors T7 angelegt. Wird nun der Schalter S1 geschlossen, dann wird das Potential am Gate des Sperrschicht-Feldeffekttransistors T7 durch die Spannungsquelle SQ1 auf einen negativen Wert gezogen, wobei der Schalter S2 offen ist. Stattdessen wird nun die Diode D1 leitend und zieht das Gate des Sperrschicht-Feldeffekttransistors T7 auf annähernd das Potential am Abgriff des Spannungsteilers. Durch den Kondensator C1, der dem Widerstand R4 parallel liegt, ändert der Spannungsteiler über der Zeit sein Teilerverhältnis dahingehend, dass zunächst die volle Spannung der Spannungsquelle SQ1 am Abgriff anliegt, während nach einer bestimmten Zeit die Spannung am Abgriff durch das Teilerverhältnis der Widerstände R4 und R5 vorgegebenen ist. Werden die Widerstände R4 und R5 klein genug und die Kapazität groß genug gegenüber den auftretenden parasitären Kapazitäten und Widerständen gewählt, dann wird das Zeitverhalten weitgehend durch die Widerstände R4 und R5 sowie den Kondensator C1 bestimmt. Zunächst wirkt dabei der Kondensator C1 wie ein Kurzschluss, der den Widerstand R4 überbrückt. Mit der Zeit lädt sich der Kondensator C1 auf und damit tritt mehr und mehr der Widerstand R4 gegenüber der Kapazität C1 in den Vordergrund. Somit gelangt beim Einschalten des Schalters S1 zunächst eine hohe Spannung an das Gate des Sperrschicht-Feldeffekttransistors T7, das dann auf den durch die Widerstände R4 und R5 vorgegebenen Spannungswert absinkt. Der Widerstand R4 bewirkt auch, dass der Kondensator C1 nach dem Öffnen des Schalters S1 schnell entladen wird.

Das Ausführungsbeispiel nach FIG 5 ist gegenüber dem in FIG 4 gezeigten Ausführungsbeispiel dahingehend abgeändert, dass anstelle der Diode D1, des Schalters S2 sowie der Spannungsquelle SQ2 zwei Stromquellen IQ1 und IQ2 verwendet werden, wobei die Stromquelle IQ2 durch eine Spannung steuerbar ist. Die Stromquelle IQ1 ist dabei zwischen das positive Versorgungspotential +V und das Gate G des Sperrschicht-Feldeffekttransistors T7 geschaltet, während die Stromquelle IQ2 zwischen das Gate G des Sperrschicht-Feldeffekttransistors T7 und das negative Versorgungspotential -V geschaltet ist. Die Spannung zur Steuerung der Stromquelle IQ2 wird dabei am Abgriff des Spannungsteilers mit den Widerständen R4 und R5 abgenommen.

Bei geöffnetem Schalter S1 wird ein positiver Strom durch die Stromquelle IQ1 bereitgestellt, der den Sperrschicht-Feldeffekttransistor T7 leitend hält. Wird nun der Schalter geschlossen, dann wird die Stromquelle IQ2 aktiviert, die betragsmäßig einen größeren Strom liefert als die Stromquelle IQ1 und somit zum einen den Strom der Stromquelle IQ1 kompensiert und zum anderen mit dem überschiessenden (negativen) Strom den Sperrschicht-Feldeffekttransistor T7 abschnürt. Wie schon bei dem Beispiel nach FIG 4 wird durch den Spannungsteiler (Widerstände R4 und R5) in Verbindung mit dem Kondensator C1 beim Einschalten des Schalters S1 zunächst eine höhere Spannung erzeugt, die dann auf einen stationären Wert abfällt. In entsprechender Weise wird somit durch die mit dieser Spannung gesteuerte Stromquelle IQ2 zunächst ein höherer Strom erzeugt, der dann ebenfalls auf einen stationären Wert abfällt.

## Patentansprüche

1. Ansteuerschaltung für einen Anschlüsse für Gate (G), Drain (D) und Source (S) aufweisenden Sperrschicht-Feldeffekttransistor (T1, T2, T4, T7, JFET) mit einer steuerbaren Strom- oder Spannungsquelle zur Erzeugung eines Sperrsteuerstromes bzw. einer Sperrsteuerspannung für das Gate (G), wobei die Strom- bzw. Spannungsquelle derart gesteuert wird, dass beim Ausschalten des Sperrschicht-Feldeffekttransistors der Sperrsteuerstrom bzw. die Sperrsteuerspannung zunächst einen betragsmäßig höheren Wert und dann einen betragsmäßig niedrigeren Wert annimmt und bereits der niedrigere Wert zum Sperren des Sperrschicht-Feldeffekttransistors ausreichend ist.

2. Ansteuerschaltung nach Anspruch 1, bei der eine Zeitsteuerung (MF) für die Stromquelle bzw. Spannungsquelle vorgesehen ist, die bei Auftreten einer das Ausschalten des Sperrschicht-Feldeffekttransistors (T4) einleitenden Flanke eines Schaltsignals (CS) den Sperrsteuerstrom bzw. die Sperrsteuerspannung von dem niedrigeren Wert für eine Überhöhungs-Zeitdauer auf den höheren Wert erhöht.

3. Ansteuerschaltung nach Anspruch 1 oder 2, bei der der höhere Wert des Sperrsteuerstromes bzw. der Sperrsteuerspannung gleich dem maximal zulässigen Wert für den Gatestrom bzw. die Gatespannung ist.

4. Ansteuerschaltung nach einem der vorherigen Ansprüche, bei der der Sperrschicht-Feldeffekttransistor ein Silizium-Carbid-Feldeffekttransistor ist.
